# EUROPEAN PATENT APPLICATION

(11) **EP 1 369 923 A1**
(43) Date of publication of application: **10.12.2003**
(21) Application number: 02405609.5
(22) Date of filing: 16.07.2002
(51) Int. Cl.: H01L 27/00, H05B 33/26, H01L 27/146

(54) **An optoelectronic device and a large-area array of optoelectronic pixels**

(30) Priority: 07.06.2002 GB 0213224
(71) Applicant: CSEM Centre Suisse d'Electronique et de Microtechnique SA, 2007 Neuchâtel (CH)
(72) Inventor: Kiy, Michael, 8404 Winterthur (CH)
(74) Representative: Patentanwälte Feldmann & Partner AG

(57) **Abstract**

An optoelectronic device (1) is essentially formed by two fibers (2, 3), each of which has an electrode (21, 31). An optically active layer (41) is located on the second fiber (3). The two fibers (2, 3) are arranged so as to intersect and be in contact at the intersection (5). Thus a stack structure (21, 41, 31) needed for optoelectronic devices is formed at the intersection. Such a stack structure (21, 41, 31) comprises a first electrode (21), e.g., an anode, an optically active layer (41) and a second electrode (31), e.g., a cathode. This resulting sandwich structure (21, 41, 31) forms a light-emitting device, a photosensitive device and/or a photovoltaic cell, depending on the operation conditions and the material composition. Large light-emitting, light-detecting and/or photovoltaic arrays may be fabricated by weaving a plurality of such fibers (2, 3). The arrays are structured in pixels (1) which can be individually addressed. Such woven pixel arrays are simple, reliable, cheap, and allow mass production of large-area devices of up to many square meters.

## Description

### Field of the invention

This invention is in the field of light generation, light detection and/or photovoltaic conversion. It relates to an optoelectronic device according to the preamble of claim 1, which device is capable, e.g., of light emission, light detection and/or photovoltaic conversion. The invention further relates to an array of optoelectronic pixels according to the preamble of a further independent claim. The invention also relates to a coated fiber according to the claim of a further independent claim. Moreover, the invention relates to methods for manufacturing such a device, such an array and such a fiber.

The array of pixels according to the invention is preferably woven of fibers provided with appropriate coatings. Its size may be up to many square meters. The array can be operated via column and row contacts. An addressing of individual pixels is possible. Application examples of a large-area array according to the invention encompass matrix displays, large advertising media, tent squares as solar-cell and light-emitting areas, embedded or encapsulated solar cells in roofing tiles, solar cells in glass windows, light-emitting clothes, or flexible document scanners.

### Background of the invention

Thin-film organic light-emitting devices (OLEDs) have been described in various publications in the past. The device structure of OLEDs typically consists of several organic layers sandwiched between an anode contact and a cathode contact. At least one of these contacts is transparent to transmit the light produced by the organic layers. The thickness of such a device is as low as several hundred nanometers in order to obtain a sufficient electric field within the two contacts.

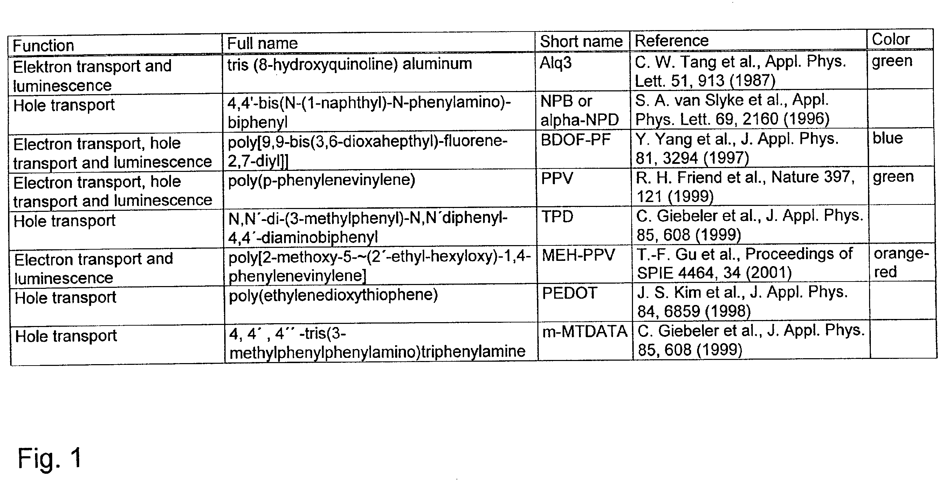

Organic light-emitting devices known from the prior art usually comprise a luminescence material and, optionally, a hole-transport and/or an electron-transport material. Some materials combine both properties. Van Slyke et al. describe in U.S. Patent No. 4, 539, 507 a bi-layer organic light-emitting device with improved device performance. Bradley et al. teach in WO-90/13148 that, instead of evaporated small molecules, also polymers can be used as organic material. The polymers can be deposited by solution-compatible thin-film deposition processes such as spin coating, inkjet printing, or doctor blade technique. Even polymer solutions or gels are described by S.C. Chang et al., ("Polymer gel light-emitting devices" Appl. Phys. Lett. 75, 2713, 1999, and "Polymer solution light-emitting device", Appl. Phys. Lett., 74, 2081, 1999) for organic light emission and highly transparent devices. **Figure 1** gives a few examples of typical materials employed from the prior art in organic optoelectronic devices.

Layer structures such as those described in the cited prior art can also be used in reverse. Then the light generates an electrical current in the device. This is described in several patent publications. For example, Tang et al. teach in U.S. Patent No. 4,281,053 the structure of an organic photovoltaic cell, and R. H. Friend et al. review in Nature 397, 121, 1999, a photovoltaic cell based on ITO/CN-PPV/MEH-PPV/Ca structures.

Also zinc-sulphur alloy sandwiched between metallic electrode contacts has been shown to generate light when a voltage is applied to the contacts.

In the paper "High performance polymer light-emitting diodes fabricated by a low temperature lamination process", Advanced Functional Materials, 11, 339, 2001, Guo et al. describe the fabrication of a laminated light-emitting diode (LED). The LED consists of two plane components, an anode sheet and a cathode sheet. The anode sheet contains an anode and a polymer layer, which can be either a hole-transport layer or a luminescent polymer. The cathode sheet contains an active luminescent material and a cathode. The two sheets are laminated together by placing them on top of each other, pressing them together and heating them at 60 °C.

In the paper "Solid-state light emitting devices based on the tris-chelated Ruthenium(II) complex 4.-high efficiency light-emitting devices based on derivates of the tris(2,2'-bipyridyl) Ruthenium(II) (Ru(bpy)₃) complex", Journal of the American Chemical Society, 124, 4918, 2002, H. Rudmann et al. describe a highly efficient light-emitting device based on electrochemical cells. An example of a light-emitting electrochemical cell (LEC) is a conjugated polymer blended with a solid electrolyte that provides mobile ions.

Large-area light-emitting sheets, displays and photovoltaic devices manufactured conventionally with organic materials require very thin layers with thicknesses in the order of several hundreds of nanometers in order to achieve high electric fields for operation at low voltages (2-20 V). Large-area production with uniform thin layers is very critical because short circuits decrease the efficiency or even can destroy the operation. Another problem is the deposition of large-area layers. Due to the high electrical fields at thin layers the layer thickness plays an important role for the device performance and operation. Conventional deposition technologies, such as spin-coating or vacuum deposition, exceed the requirements for homogeneous thin layers in case of large substrates.

European publication EP-A-1'180'805 describes a flexible OLED fiber light source. It consists of a fiber core coated with a cathode, an organic radiation-emitting layer and a transparent anode. Such a fiber light source could be appropriately embedded in order to obtain a large-area light-emitting sheet. However, addressing of individual pixels would not be possible.

### Summary of the invention

It is an object of the invention to provide an optoelectronic device and a method for manufacturing such a device which avoid the disadvantages of the prior art described above. It is yet a further object of the invention to provide a large-area optoelectronic device which avoids the disadvantages of the prior art described above. In particular, the functioning of the whole device should not be jeopardized by possible short circuits. It is desirable to individually address certain pixels of the device. The manufacturing method should be simple, reliable, cheap, and should allow mass production of large-area devices of up to many square meters.

These and other objects are solved by the optoelectronic device, the array of optoelectronic pixels, the coated fiber and the methods for manufacturing the same as defined in the independent claims. Advantageous embodiments are defined in the dependent claims.

The invention is based on the idea of providing two fibers, each of which has an electrode; at least one optically active layer is located on any of the two fibers. The two fibers are arranged so as to intersect and be in contact at the intersection. Thus a stack structure needed for optoelectronic devices is formed at the intersection. Such a stack structure comprises a first electrode, e.g., an anode, an optically active layer and a second electrode, e.g., a cathode. This resulting sandwich structure forms a light-emitting device, a photosensitive device and/or a photovoltaic cell, depending on the operation conditions and the material composition.

Thus, an optoelectronic device according to the invention has a stack structure, said stack structure comprising a first electrode and a second electrode, and an optically active region placed between said first and said second electrode and comprising at least one optically active layer, a first surface of said region being in contact with said first electrode and a second surface of said region being in contact with said second electrode. The device further comprises at least a first and a second fiber, said first electrode being located on said first fiber, said second electrode being located on said second fiber and said at least one optically active layer being located on any of said first and second fibers. Said first fiber and said second fiber intersect and are in contact at the intersection so that said stack structure is formed at the intersection.

A fiber suitable for device according to the invention is a body with a length in axial direction which is much larger, e.g., at least two orders of magnitude larger, than its extent in any radial direction. The fiber may have any cross-section profile, such as rectangular, circular or oval. Its surface should be smooth. The fiber must be electrically conductive at least at the surface and mechanically flexible. Metal wires or coated flexible longish substrates, such as plastics, glass fibers with metal coating, indium tin oxide (ITO), or a conductive organic material can be used for this purpose.

At least one of the two fibers is coated with at least one optically active layer with electro-luminescent or photo-absorption properties, e.g., with organic semiconductors, polymers, or zinc-sulphur alloys.

In particular, the fiber suitable for the device according to the invention is coated with at least one layer. The fiber comprises a fiber substrate, an electrode and an optically active region placed on top of said electrode and comprising at least one optically active layer. The layer furthest from the fiber is said optically active layer or one of said optically active layers.

Large light-emitting, light-detecting and/or photovoltaic arrays may be fabricated by weaving a plurality of such fibers. Such arrays are structured in pixels which can be individually addressed. Accordingly, in an array of optoelectronic pixels according to the invention, said pixels are optoelectronic devices according to the invention, as described above. In a preferred embodiment, the array according to the invention comprises a plurality of fibers of a first type which are essentially identical to the first fiber of the optoelectronic device, and a plurality of fibers of a second type which are essentially identical to the second fiber of the optoelectronic device, wherein said fibers are arranged essentially in one surface plane so that at least one fiber of the first type and one fiber of the second type intersect and at the intersection, the two fibers of different types are in contact with each other.

Large-area light-emitting arrays, light-detecting arrays and/or photovoltaic arrays may be fabricated with weaving technology. The coated fibers are woven in order to obtain a fabric, e.g., a lattice fabric made of warp threads (e.g., fibers without optically active layers) and weft threads (e.g., fibers with an optically active layer). Weaving machines as used for textile production can be employed. After the weaving the resulting fabric can be cut, some wires removed, and the optically active layer can be chemically removed to expense the contacts. The anode and the cathode are then accessible for contacting. The fabric is flexible and can be encapsulated afterwards for environmental (oxygen, water) and mechanical protection. Such woven devices are inherently structured in pixels, which are formed by the intersections of the warp and weft threads, and can be operated via column and row contacts.

The invention overcomes the problems of the prior art. Only a small fiber has to be coated, even in case of very large fabric areas. The coating of the fiber can be done by methods described in EP-A-1'180'805. The devices are structured in small pixels and therefore the probability for short circuits is reduced. Individual addressing of pixels is possible.

Further advantages offered by the invention are the following:
- The manufacturing process itself patterns the device into a matrix structure. No shadow masks or photolithography are involved in the manufacturing process.
- Large-area mass production of solar cells, light-emitting structures or photo detectors is possible with a relatively small deposition area, since only the fibers have to be coated.
- The fabric can be cut in application size after the production and can be contacted afterwards.
- The fabric is flexible and mechanically stable. It can be embedded in encapsulation material.

### Brief description of the drawings

Embodiments of the invention are described in greater detail hereinafter relative to the attached schematic drawings.
- Figure 1: shows a table of materials for organic light-emitting devices used in the prior art which are also usable for the invention.
- Figure 2: shows a schematic perspective view of a simple device according to the invention.
- Figure 3: shows a top view of a pixel array according to the invention.
- Figure 4: shows a cross section along line IV-IV through the array of Fig. 3.
- Figure 5: shows an enlarged detail of the cross section of Fig. 4.
- Figure 6: shows cross sections through further embodiments of the array according to the invention.
- Figures 7 and 8: show the use of the array according to the invention as a light-emitting device and as a photovoltaic cell, respectively.
- Figure 9: shows a schematic circuit diagram for the combined use of the array according to the invention as a photovoltaic cell and as a light-emitting device.
- Figure 10: shows the use of the array according to the invention as a passive matrix display.
- Figure 11: shows an embodiment of the array according to the invention with a permanent pattern.

### Description of preferred embodiments

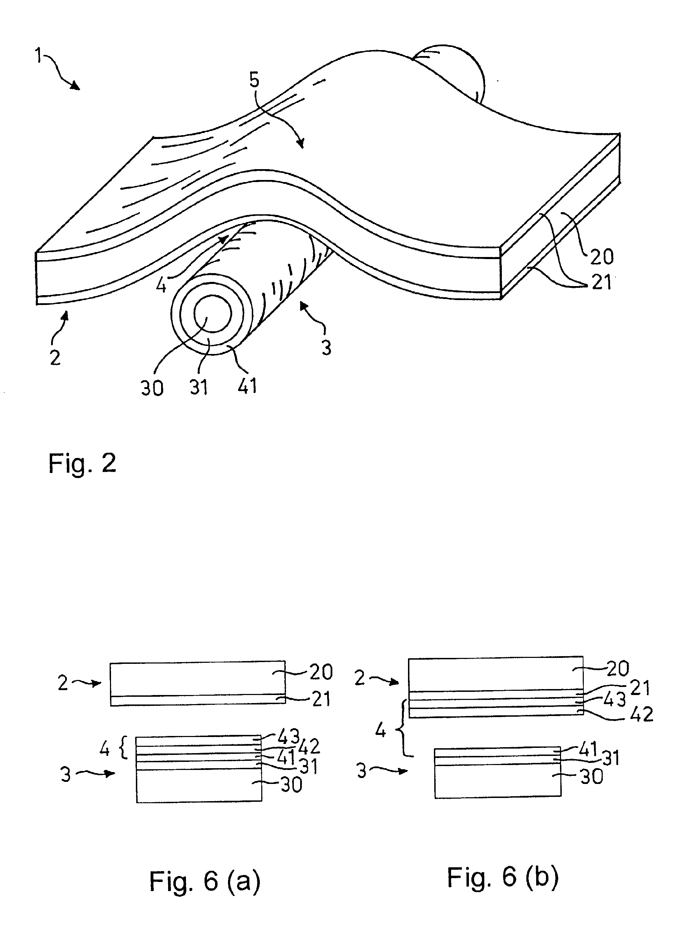

A schematic perspective view of a simple device 1 according to the invention is shown in **Figure 2**. The device 1 comprises two fibers: a first fiber 2 of a first fiber type which is electrically conductive at least at the surface, and a second fiber 3 of a second fiber type which is electrically conductive at least at the surface and is coated with an optically active layer 41. The fibers preferably intersect in an essentially right angle, thereby forming an intersection 5; of course, other intersection angles are also possible. In the embodiment of Fig. 2, the first fiber 2 has a rectangular cross section, whereas the second fiber 3 has a circular cross section. With this geometry, a large contact surface between the two fibers 2, 3 at the intersection is achieved.

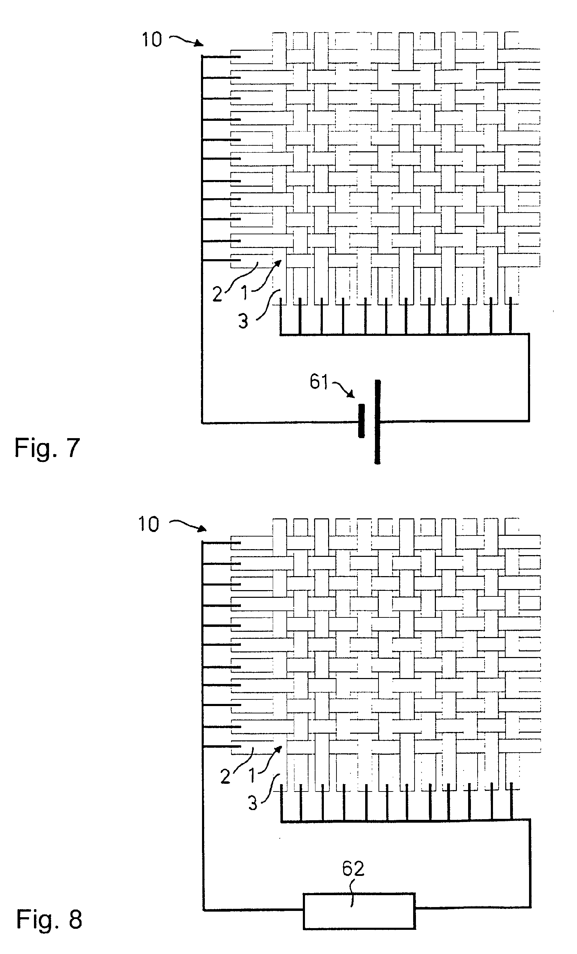

The first fiber 2 comprises a first substrate 20 which is, e.g., a stripe of a plastic foil. The first substrate 20 is coated with a ITO layer 21 acting as an anode. The second fiber 3 comprises a second substrate 30 which is, e.g., a glass fiber. The second substrate 30 is coated with an aluminum layer 31 acting as a cathode and, additionally, an optically active layer 41 such as PPV (cf. Fig. 1). The thicknesses of the fiber substrates 20, 30 are chosen so as to provide the desired mechanical properties such as tensile strength and flexibility. The thicknesses of the electrodes 21, 31 are chosen so as to provide the desired electric conductivity. The thickness of the optically active layer 41 is preferably between about 20 nm and 1000 nm in order to achieve high electric fields for operation at low voltages (2-20 V). Further layers, e.g., further optically active layers, could be provided (cf. Fig. 6). Some materials suitable for such layers are listed in Fig. 1; however, this list is not exhaustive of course. The coatings 21, 31, 41 can be deposited by evaporation, by dip-coating or by other coating methods known from microelectronics, optics and/or micromechanics technology. In this example, the two fibers 2, 3 have different geometric shapes and different coatings 21, 31; they could also have identical geometries and/or coatings.

The layer structure resulting at the intersection 5 of the two fibers 2, 3 forms an optically active region 4, e.g., a light-emitting device. Light is emitted if an appropriate voltage is applied to the two fibers 2, 3.

The fibers 2, 3 guide the electrical current to the optically active region 4. In the optically active region 4, one fiber 2 acts as an anode and the other fiber 3 as a cathode. If polymers or organic materials are used as the optically active layer 41, in case of the anode the metal of the fiber 2 or the anode coating 21 on the surface of the fiber 2 should be a material with high work function (e.g., gold, platinum, ITO) or an organic conductive material with hole-injection properties into the active material 41. For the cathode a material with a low work function (e.g., Mg, Ca, Li, Al, an Mg:Ag alloy) or an organic conductor with electron-injection properties or even ITO can be used. For transmitting the light in radial direction (e.g., in a direction perpendicular to the surface plane defined by the two fibers 2, 3) the fiber substrates 20, 30 and their coatings 21, 31 should be transparent (e.g., plastic substrates coated with ITO).

The fiber substrates 20, 30 may consist of an electrically non-conductive material such as a plastic foil or a glass fiber. In this case, they must be coated with an electrically conductive layer 21, 31 such as an ITO or a metal layer. Alternatively, conductive materials such as metal wires or metal foils can be used for the fiber substrates 20, 30. Then the fiber substrates 20, 30 themselves will act as electrodes, and it will not be necessary to provide separate electrode coatings.

The fibers 2, 3 might be coated only in part, e.g., one side in case of rectangular fibers (cf. Fig. 6).

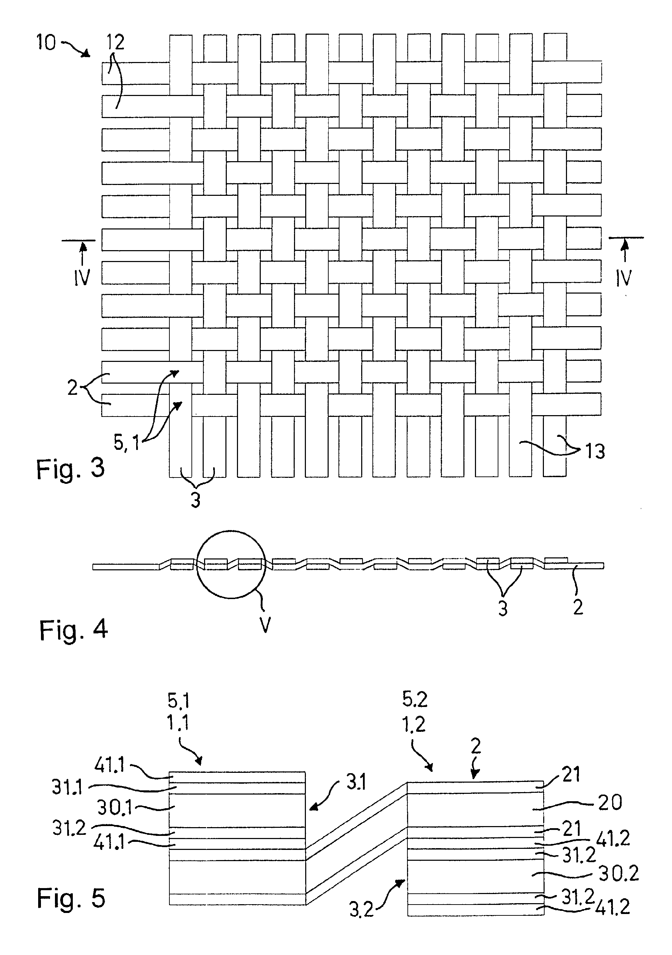

**Figure 3** shows a top view of a simple woven structure, fabric, matrix or array 10 according to the invention. It is a lattice fabric made of parallel warp threads 2 which are, e.g., fibers of the first type, and parallel weft threads 3 which are, e.g., fibers of the second type. The first-type fibers 2 and the second-type fibers 3 intersect in essentially right angles. The intersections 5 form optically active pixels 1 of the array. In this woven structure 10, a fiber which is on top at a certain intersection is underneath at both adjacent intersections, and vice versa. This structure ensures a sufficient mutual contact pressure between two intersecting fibers 2, 3.

Alternatively, the fibers of the first type 2 could simply be placed on top of the fibers of the second type 3 to form a lattice, instead of weaving. In this case, a sufficient contact pressure at the intersections 5 should be ensured by appropriate measures. The fibers 2, 3 could be maintained in a defined mutual relative position by adhesive materials. However, this would substantially change the mechanical properties of the structure compared to the woven structure shown in Fig. 3, where the fibers 2, 3 are displaceable relatively to each other at the intersections 5.

Organic optically active materials are sensitive to water, oxygen and other substances, i.e., deteriorate upon contact with these substances. Therefore, if organic optically active materials are used, the fabric 10 such as shown in Fig. 3 should be appropriately encapsulated in order to protect the active material 41 from contact with the atmosphere. For this purpose, a (not shown) protection layer can be deposited on one or both surfaces of the fabric 10. Such a protection layer should be a diffusion barrier for water and oxygen; moreover, it should preferably be mechanically flexible. Alternatively, only the intersections 5, which form the pixels of the array 10, could be appropriately encapsulated. The latter alternative would give the fabric 10 a better mechanical flexibility; however, in both cases, the mechanical flexibility of the fabric 10 would deteriorate due to all measures which impede a relative displacement of the fibers 2, 3 at the intersections 5.

A simple, however not mechanically flexible, example of a protective encapsulation is to sandwich the fabric of Fig. 3 between two (not shown) epoxy-coated glass sheets in a leakproof way. The glass sheets act as water- and oxygen-diffusion barriers, the epoxy (or an other adhesive) as a mechanical joining. At electrical connection areas or contacts 12, 13 at the edges of the fabric 10, an encapsulation is not necessary.

The embodiment shown in Fig. 3 is a two-dimensional array 10. The invention encompasses also one- and three-dimensional arrays of optoelectronic devices. In the latter instance, a plurality of essentially parallel two-dimensional arrays could be assembled to form a three-dimensional array, or a real three-dimensional structure could be made of the two fiber types.

**Figure 4** shows a cross section along line IV-IV through the fabric of Fig. 3. In this embodiment, the fibers 2, 3 have rectangular cross sections.

A detail marked by V in the cross section of Fig. 4 is shown in **Figure 5**. In this enlarged graphic representation the layers 21, 31, 41 are visible; the layer thicknesses are not necessarily represented in the same scale as the fiber substrates 20, 30. In analogy to Fig. 2, a first fiber 2 of a first fiber type and two second fibers 3.1, 3.2 of a second fiber type are shown. The first fiber 2 is coated with an anode material 21; the second fibers 3.1, 3.2 are coated with a cathode material 31.1, 31.2 and an optically active layer 41.1, 41.2. The intersections 5.1, 5.2, where the first fiber 2 and the second fiber 3.1, 3.2 are in close contact, form optically active pixels 1.1, 1.2.

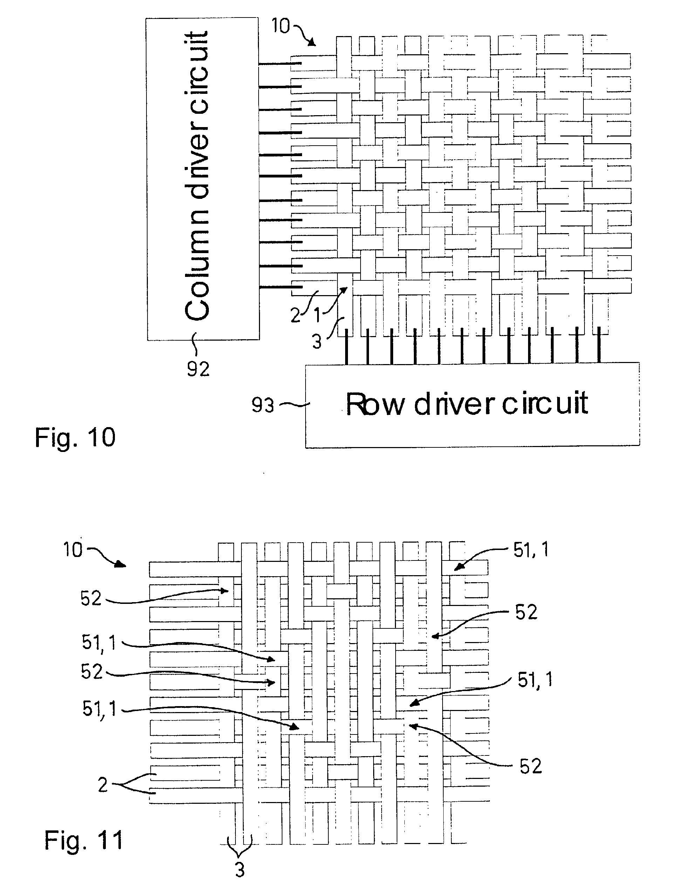

The embodiment of Fig. 5 is only a special case in which the optically active region 4 consists of one single optically active layer 41. It may be desirable to have an optically active region 4 comprising a plurality of optically active layers. Such composed optically active regions may have a higher efficiency, or optically active layers emitting different colors may be chosen. **Figure 6** shows two schematic examples of devices according to the invention with three optically active layers 41-43. For the sake of clarity, the two fibers 2, 3 are drawn separated from each other; as emphasized above, they must be in close contact in order to make the device work. In contrast to the embodiment of Fig. 5, Fig. 6 shows an example where the fibers 2, 3, having rectangular cross sections, are coated only on the sides facing each other, but not on the opposite sides. Fibers coated in this manner are advantageous for forming fabrics with permanent patterns, as described with reference to Fig. 11.

**Figure 6(a)** shows an embodiment in which only the anode layer 21 is located on the first fiber 2, whereas the cathode layer 31 and all three optically active layers 41-43 are located on the second fiber 3. In the embodiment of **Figure 6(b)**, the anode layer 21 and two optically active layers 41, 42 are located on the first fiber 2 and the cathode layer 31 and a third optically active layer 43 are located on the second fiber 3. When the two fibers of Fig. 6(b) are brought together, the three optically active layers 41-43 will form an optically active region 4 sandwiched between the two electrodes 21, 31.

If the optoelectronic device 1 or the array 10 according to the invention is used for light emission, an electric voltage, e.g., supplied by a battery 61, has to be applied at the contacts 12, 13, as indicated in **Figure 7**. Otherwise, in case of light detection or current generation by light in a photovoltaic cell, the pixels 1 are connected to a voltage/current consumer or battery 62, respectively, as shown in **Figure 8**.

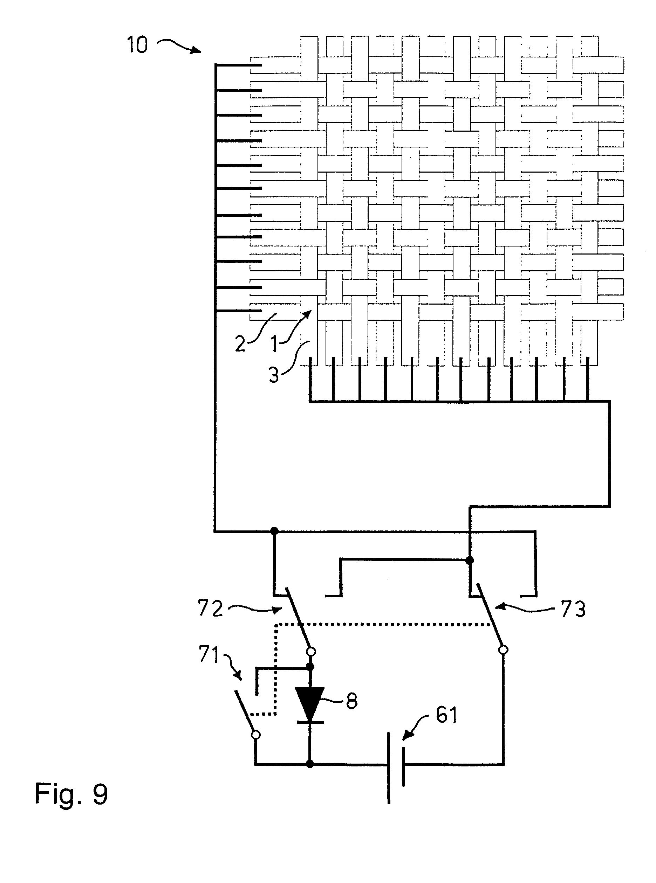

The fabric 10 according to the invention can be used to charge a battery 61 via photovoltaic conversion, e.g., during the day, and afterwards, e.g., during the night, to generate light by discharging the battery 61. A simple electric circuit that makes this possible is schematically illustrated in **Figure 9**. The mode of operation is changed by simultaneously actuating three switches 71-73. In Figure 9, the switch positions are shown to be in the charging mode. In this mode, a diode 8 prevents the device from emitting light.

The array 10 according to the invention can be operated as a matrix of pixels 1 with column and row selection, as indicated in **Figure 10**. Each pixel 1 can be addressed individually. Column driver circuits 92 and row driver circuits 93 are well known from the prior art, e.g., from active-pixel sensors (APS). The array 10 of Fig. 10 can thus be used, e.g., to display variable patterns such as temporarily changing text or moving pictures.

If, on the other hand, only invariable patterns shall be displayed, a desired permanent pattern such as shown in **Figure 11** can be woven during the fabrication. For this purpose, only one side of each strip-like fiber 2, 3 may be coated, e.g., the bottom sides of warp threads 2 and the top sides of the weft threads 3, as shown in Fig. 6. Only intersections 51 at which a warp thread 2 is on top and a weft thread 3 is underneath form optically active pixels 1 of the device. "Blind" intersections 52 for which the above condition is not true are not active. Such permanent patterns 10 allow an easy fabrication of light-emitting letters, signs, logos or other patterns and reduce the effort in driving circuits for fixed or blinking structures.

Thus, three types of the pixel array 10 according to the invention have been described:
- In Fig. 7:: a permanent homogeneous distribution of active pixels;
- In Fig. 11:: a permanent pattern of active pixels; and
- In Fig. 10:: individually addressable pixels, with which a variation in time of a pattern displayed is possible.

This invention is not limited to the preferred embodiments described above, to which variations and improvements may be made, without departing from the scope of protection of the present patent.

### List of reference signs

- 1: Optoelectronic device

- 10: Array

- 12, 13: Contacts

- 2: First fiber
- 20: First substrate
- 21: First electrode

- 3: Second fiber
- 30: Second substrate
- 31: Second electrode

- 4: Optically active region
- 41-43: Optically active layers

- 5: Intersection
- 51: Intersection that can be activated
- 52: Blind intersection

- 61: Battery
- 62: Voltage/current consumer or battery

- 71-73: Switches

- 8: Diode

- 92: Column driver circuit
- 93: Row driver circuit

## Claims

1. An optoelectronic device (1) with a stack structure (21, 41-43, 31), said stack structure (21, 41-43, 31) comprising
a first electrode (21) and a second electrode (31), and
an optically active region (4) placed between said first (21) and said second electrode (31) and comprising at least one optically active layer (41-43),
a first surface of said region (4) being in contact with said first electrode (21) and a second surface of said region (4) being in contact with said second electrode (31),
**characterized in that**
the device (1) comprises at least a first (2) and a second fiber (3),
said first electrode (21) being located on said first fiber (2), said second electrode (31) being located on said second fiber (3) and said at least one optically active layer (41-43) being located on any of said first (2) and second (3) fibers, and
said first fiber (2) and said second fiber (3) intersect and are in contact at the intersection (5) so that said stack structure (21, 41-43, 31) is formed at the intersection (5).

2. The optoelectronic device (1) according to claim 1, wherein said first fiber (2) and/or said second fiber (3) comprises a metal wire, a flexible longish plastic substrate or a glass fiber, and is preferably coated with at least one conductive layer (21, 31) such as indium tin oxide, a metal, or a conductive organic material.

3. The optoelectronic device (1) according to any of the preceding claims, wherein said first fiber (2) and/or said second fiber (3) is transparent for light in a certain spectral range.

4. The optoelectronic device (1) according to any of the preceding claims, wherein said at least one optically active layer (41-43) is selected from the group consisting of Alq3, NPB or alpha-NPD, BDOF-PF, PPV, TPD, MEH-PPV, PEDOT, m-MTDATA and zinc-sulphur alloys.

5. The optoelectronic device (1) according to any of the preceding claims, wherein said first electrode (21) comprises a material with high work function, e.g., gold, platinum or ITO, or an organic conductive material with hole-injection properties into the adjacent optically active layer (41), and said second electrode (31) comprises a material with a low work function, e.g., Mg, Ca, Li, Al, an Mg:Ag alloy or ITO, or an organic conductor with electron-injection properties into the adjacent optically active layer (43).

6. The optoelectronic device (1) according to any of the preceding claims, wherein at least one of said fibers (2, 3) has an essentially rectangular cross-section, and the layers (41-43) necessary for forming said stack structure (21, 41-43, 31) are located on the side facing the other fiber, but not on the opposite side.

7. The optoelectronic device (1) according to any of the preceding claims, the device being encapsulated in a protection coating which is a diffusion barrier for water and oxygen.

8. An array (10) of optoelectronic pixels (1),
**characterized in that**
said pixels (1) are optoelectronic devices according to any of the preceding claims.

9. The array (10) according to claim 8, comprising a plurality of fibers (2) of a first type which are essentially identical to the first fiber (2) of the optoelectronic device (1), and a plurality of fibers (3) of a second type which are essentially identical to the second fiber (3) of the optoelectronic device, wherein said fibers (2, 3) are arranged essentially in one surface plane so that at least one fiber (2) of the first type and one fiber (3) of the second type intersect and at the intersection (5), the two fibers (2, 3) of different types are in contact with each other.

10. The array (10) according to claim 9, wherein said fibers (2) of the first type are essentially parallel to each other, said fibers (3) of the second type are essentially parallel to each other, and the fibers (2) of the first type and the fibers (3) of the second type intersect in essentially right angles.

11. The array (10) according to claim 9 or 10, wherein said fibers (2, 3) are woven together, thus forming a fabric, preferably a lattice fabric.

12. The array (10) according to claim 11, wherein all intersections (5) of the array (10) are optically active.

13. The array (10) according to claim 11, wherein only certain intersections (51) of the array are optically active, whereas the other intersections (52) cannot be activated, the intersections (51, 52) thus forming a permanent pattern.

14. The array (10) according to any of claims 8-13, the array (10) being encapsulated in a protection coating which is a diffusion barrier for water and oxygen.

15. The array (10) according to any of claims 8-14, wherein fibers (2, 3) are connected to a voltage source (61), the array (10) being usable as a light-emitting array.

16. The array (10) according to any of claims 8-14, wherein fibers (2, 3) are connected to a voltage or current consumer or to a battery (62), the array being usable as a photovoltaic array.

17. The array (10) according to claims 15 and 16, wherein fibers (2, 3) are connected to a battery, the array (10) further comprising an electric circuit with at least one switch (71-73) for switching between a first operation mode in which the array (10) is usable as a photovoltaic array and a second operation mode in which the array (10) is usable as a light-emitting array.

18. The array (10) according to any of claims 8-14, wherein fibers (2, 3) are connected to a voltage or current consumer (62), the array (10) being usable as a light-detecting array.

19. The array (10) according to any of claims 8-18, additionally comprising a column driver circuit (92) and a row driver circuit (93) for addressing individual pixels (1).

20. A fiber (3) coated with at least one layer (31, 41-43), said fiber (3) comprising
a fiber substrate (30)
an electrode (31) and
an optically active region (4) placed on top of said electrode (31) and comprising at least one optically active layer (41-43),
**characterized in that**
the layer (43) furthest from said fiber substrate (30) is said optically active layer (41) or one of said optically active layers (41-43).

21. A method for manufacturing a coated fiber (3) as defined in claim 20, comprising the steps of:
providing a fiber (3) comprising an electrode (31) and
coating said fiber (3) with at least one optically active layer (41-43),
**characterized in that**
the last layer (43) with which said fiber (3) is coated is an optically active layer.

22. A method for manufacturing an optoelectronic device (1) as defined in claim 1,
**characterized by** the steps of:
providing a first fiber (2) comprising a first electrode (21),
providing a second fiber (3) comprising a second electrode (31),
coating at least said second fiber (3) with at least one optically active layer (41-43), and
arranging said first (2) and said second fiber (3) so that they intersect and are in contact at the intersection (5).

23. A method for manufacturing an array (10) of optoelectronic pixels as defined in claim 9,
**characterized by** the steps of:
providing a plurality of fibers (2) of a first type, each of said fibers (2) of the first type comprising a first electrode (21),
providing a plurality of fibers (3) of a second type, each of said fibers (3) of the second type comprising a second electrode (31),
coating at least each of said fibers (3) of the second type with at least one optically active layer (41-43), and
arranging said fibers (2, 3) essentially in one surface plane so that at least one fiber (2) of the first type and one fiber (3) of the second type intersect and at the intersection (5), the two fibers (2, 3) of different types are in contact with each other.

24. The method according to claim 23, wherein said fibers (2, 3) are woven together, thus forming a fabric (10), preferably a lattice fabric.
